# EUROPEAN PATENT APPLICATION

(11) **EP 1 339 258 A1**
(43) Date of publication of application: **27.08.2003**
(21) Application number: 00978080.0
(22) Date of filing: 01.12.2000
(51) Int. Cl.: H05B 3/12, H05B 3/14, H05B 3/10, H05B 3/68, H05B 3/20, H01L 21/027

(54) **CERAMIC HEATER, AND CERAMIC HEATER RESISTOR PASTE**

(71) Applicant: IBIDEN CO., LTD., Ogaki-shi Gifu-ken 503-8604 (JP)
(72) Inventor: ZHOU, Yanling, Ibi-gun, Gifu 501-0695 (JP)
(74) Representative: Maiwald Patentanwalts GmbH
(86) International application number: JP0008551
(87) International publication number: WO02045465

(57) **Abstract**

A ceramic heater in which a resistor is firmly fixed onto a ceramic substrate. The resistor comprises at least two or more kinds of noble metal particles, ruthenium dioxide, and a glass frit.

## Description

### Technical Field

The present invention relates to a ceramic heater and a resistor paste for the ceramic heater used in the fabrication process of semiconductor products.

### Background Art

In a semiconductor fabricating process, for example, a silicon wafer is spin-coated with a resin and then is subjected to exposure and development processing before being postcured, and hence, it is necessary to heat the wafer. In addition, because CVD and plasma etching are carried out, it is necessary to heat the wafer.

For this reason, for example, Japanese Unexamined Patent Publication No. Hei 11-40330 proposes a heater in which a heating element is formed on a surface of a ceramic substrate.

A substrate made of alumina has conventionally been used as the substrate for such a heater. Recently, however, much attention has been paid to the substrate made of aluminum nitride, which has superior electric insulation, high heat conductivity, and a low thermal expansion coefficient.

As a resistor paste used for providing a heating element on such an aluminum nitride material, a resistor paste has heretofore been known in which noble metal particles are mixed as a conductive material. Among the noble metals, silver is superior in heat resistance and superior in adhesive properties to aluminum nitride, so that in this respect, silver is considered to be a preferable material. However, if the resistor paste containing only silver is used, it has a disadvantage that the resistance of the resistor becomes low.

Therefore, conventionally, platinum or palladium has been added to the paste, in addition to silver. However, because these noble metals are expensive, an oxide, such as a glass frit, is further added to the paste appropriately.

However, if an oxide such as a glass frit is added, when the paste is baked the oxide reacts with aluminum nitride to release a large amount of a high-pressure nitrogen gas. Therefore, this fact poses a problem in that such a nitrogen gas causes the resistor to float above the aluminum nitride substrate, thereby reducing adhesive strength.

For example, the resistor for an aluminum nitride heater disclosed in Japanese Unexamined Patent Publication No. Hei 4-300249 comprises one or more kinds of metal powders selected from the group consisting of platinum, palladium, silver, and gold, and the glass frit whose crystallization temperature is 700°C or higher (ZnO-B₂O₃-SiO₂-based glass or the like). Area resistivity of the resistor after baking is between at least 0.5 Ω per square and 10 Ω per square, and the resistor is bonded to the aluminum nitride substrate with an adhesive strength of 4.5 kgf/2 mm-square to 7.0 kgf/2 mm-square. However, also in the resistor that is disclosed in the above publication, it is assumed that the adhesive strength is reduced owing to the nitrogen gas. That is, it is difficult to state that the resistor is sufficiently bonded to the aluminum nitride substrate with an adhesive strength of about 4.5 kgf/2 mm-square to about 7.0 kgf/2 mm-square.

### DISCLOSURE OF THE INVENTION

It is a main object of the present invention to provide a ceramic heater in which a resistor is more firmly bonded to a nonoxide ceramic substrate, such as an aluminum nitride substrate or a silicon carbide substrate. A second object of the present invention is to provide a resistor paste for the ceramic heater which makes it possible to obtain by baking a resistor superior in adhesive strength.

The ceramic heater and the resistor paste for the ceramic heater that have been improved are provided o solve problems that have been described above and problems thereof in accordance with such objects.

The present inventors have earnestly carried out research in order to solve such problems. As a result, they have found out that if ruthenium dioxide is mixed into at least two kinds of noble metal particles to make a paste, and the paste is baked onto the aluminum nitride substrate or the silicon carbide substrate, a resistor is formed that is superior in adhesive strength. The present inventors have completed the invention based on these findings.

More specifically, the present invention relates to a ceramic heater in which a register is provided on a ceramic substrate, wherein the resistor comprises ruthenium dioxide, a glass frit, and at least two kinds of noble metal particles.

Furthermore, the present invention relates to a resistor paste for the ceramic heater that comprises noble metal particles, ruthenium dioxide, a glass frit, and an organic vehicle.

Generally, when a resistor paste containing an oxide such as a glass frit is sintered, for example, it causes a reaction of AlN + PbO → alumina + Pb + N₂↑. However, addition of ruthenium dioxide to the AlN and PbO causes other reactions such as 2RuO₂ + 2PbO → Ru₂Pb₂O₆ and 2RuO₂ + Bi₂O₃ → Ru₂Bi₂O₇. Therefore, it is considered that the generation of the nitrogen gas is inhibited.

Furthermore, a complex compound such as Ru₂Pb₂O₆ and Ru₂Bi₂O₇ comprising the ruthenium, glass frit, and oxygen exists in the interface between the aluminum nitride substrate and the resistor (metal sintered product), and is considered to have a function of complementing the adhesion of the two.

It has been confirmed that the adhesive strength of the resistor to the aluminum nitride substrate becomes about 14 kgf/2 mm-square to 17 kgf/2 mm-square by such complementation of the adhesive properties, which values are extremely large as compared with the prior art.

The similar reaction can also be recognized when the substrate material is changed to silicon carbide. That is, there occurs a reaction of SiC + PbO (+SiO₂) → silica + Pb + Co↑. However, the addition of ruthenium dioxide to the SiC and PbO (and SiO₂) brings about other reactions, thereby inhibiting the generation of CO.

Furthermore, as the present invention uses two or more kinds of noble metal particles, it is possible to increase the resistance of the resistor.

### BRIEF DESCRIPTION OF THE DRAWINGS

Fig. 1 is a plan view showing a ceramic heater in which a resistor is formed on a ceramic substrate.
Fig. 2 is a partially omitted sectional view of the line 1-1 of Fig. 1.
Fig. 3A is an illustration showing an adhesion state between the resistor containing ruthenium dioxide and the ceramic substrate.
Fig. 3B is an illustration showing an adhesion state between the resistor that contains no ruthenium dioxide and the ceramic substrate.
Fig. 4 is a table showing paste compositions of Reference Examples and Comparative Example and test results when these pastes are used.

### BEST MODE FOR CARRYING OUT THE INVENTION

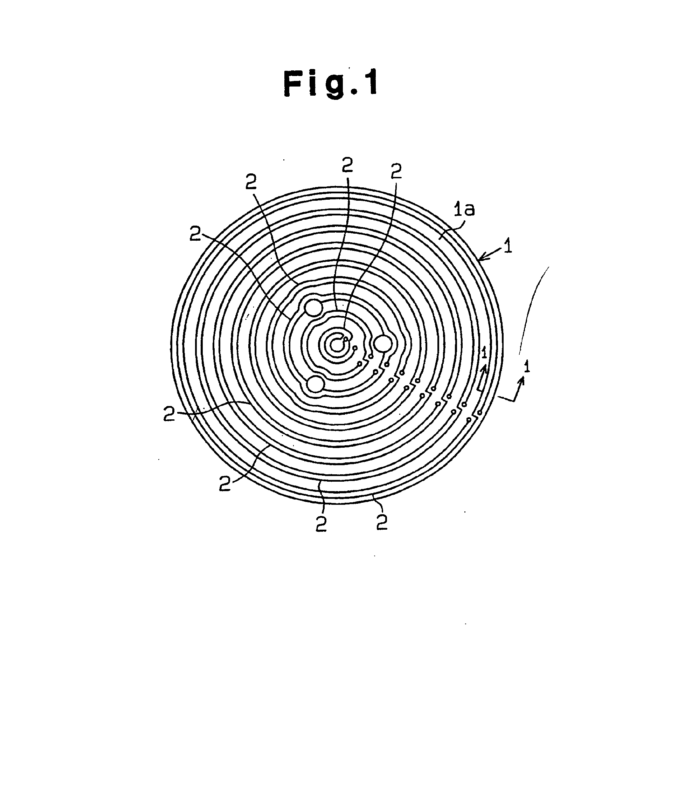

Next, a ceramic heater in an embodiment of the present invention will be described in accordance with Fig. 1 to Fig. 4.

A resistor paste for the ceramic heater in the present embodiment comprises noble metal particles including silver or gold as the main component, and ruthenium dioxide, a glass frit and an organic vehicle.

As such noble metal particles, at least one kind or at least two kinds may be selected from silver particles, gold particles, platinum particles, and palladium particles. A mixture of the noble metal particles or alloy particles of the noble metals may be used.

It is preferable that an average particle diameter of the noble metal particles be in a range of about 0.1 µm to 10 µm. This is because if the average particle diameter is too small, the noble metal particles tend to be easily oxidized. It is also because if the average particle diameter is too large, the paste is difficult to sinter, and the resistance of a resistor 2 to be obtained increases.

Furthermore, as the shape of the noble metal particles is not specifically limited, it is possible to use spherical particles, scaly particles, or a mixture of the spherical particles, scaly particles and the like. Among these, it is preferable to select scaly particles in view of good adhesive properties to aluminum nitride.

As the noble metal particles to be contained in the paste, only one kind, that is, the silver particles may normally be used. In this case, it is advantageous in view of cost or the like. However, if it is not possible to obtain the desired resistance using only the silver particles, the noble metals other than silver, that is, the noble metal particles selected from the gold particles, platinum particles and palladium particles may be blended at an appropriate ratio. The blend ratio at this time may be decided appropriately.

In addition, a small quantity of base metal particles of nickel, copper, zinc, or the like may be mixed to such an extent as not to impair the effects of the present invention.

Ruthenium dioxide reacts with the oxide contained in the paste to inhibit the generation of the nitrogen gas.

Furthermore, SiO₂-B₂O₃-ZnO₂-based glass, for example, may mainly be used as the glass frit.

The composition of the glass frit is not particularly limited. For example, it is preferable to blend it in such ranges as 1 wt% to 30 wt% of SiO₂, 5 wt% to 50 wt% of B₂O_{3,} and 20 wt% to 70 wt% of ZnO₂ relative to the total amount of the frit. In addition to this may be appropriately mixed at least one material selected from oxides such as Al₂O₃, Y₂O₃, PbO, CdO, Cr₂O₃, CuO, Bi₂O₃ and TiO₂ or a bismuth single material and the like.

It is preferable that the glass frit be amorphous. It is preferable that the glass softening point temperature of the glass frit be from 300°C to 650°C. If this temperature is too low, it causes seeping when the resistor 2 is baked, which causes an inter-pattern short. If the temperature is too high, it is not possible to have the sufficient adhesive strength.

In order to apply the mixture of the noble metal particles and the like onto a ceramic base material 1, the organic vehicle functions to bring the mixture into a paste state. It is possible to use a known organic vehicle as the organic vehicle.

Such an organic vehicle is, for example, a vehicle comprising a resin binder, such as ethyl cellulose, methyl cellulose or an acrylic resin, and a solvent such as α-terpineol or butylcarbitol.

A blend ratio of the respective materials that constitute the paste is not specifically limited. However, it is preferable that they are blended in a range of 55 wt% to 80 wt% of noble metal particles, 0.5 wt% to 10 wt% of ruthenium dioxide, 5 wt% to 20 wt% of the glass frit, 1 wt% to 10 wt% of the resin binder, and'10 wt% to 30 wt% of the solvent with respect to the total amount of the paste.

For example, as shown in Fig. 1, the resistor paste regarding the present invention is applied into a predetermined shape onto one surface 1a of a disk-shaped ceramic substrate 1 (e.g., an outside surface of the substrate or an inside surface of the substrate) by an appropriate method such as a screen printing method.

The resistor paste is baked in a nitrogen atmosphere at about 700°C to about 900°C, so that the resistor paste closely sticks to the ceramic substrate 1. As a result, a ceramic heater is produced in which a resistor 2 (heating element) is formed on the ceramic substrate 1.

It is to be noted that the surface of the resistor 2 is preferably covered with a metal layer made of a non-oxidative metal, such as gold, silver, palladium, platinum, or nickel, so as to prevent the resistor 2 from being oxidized.

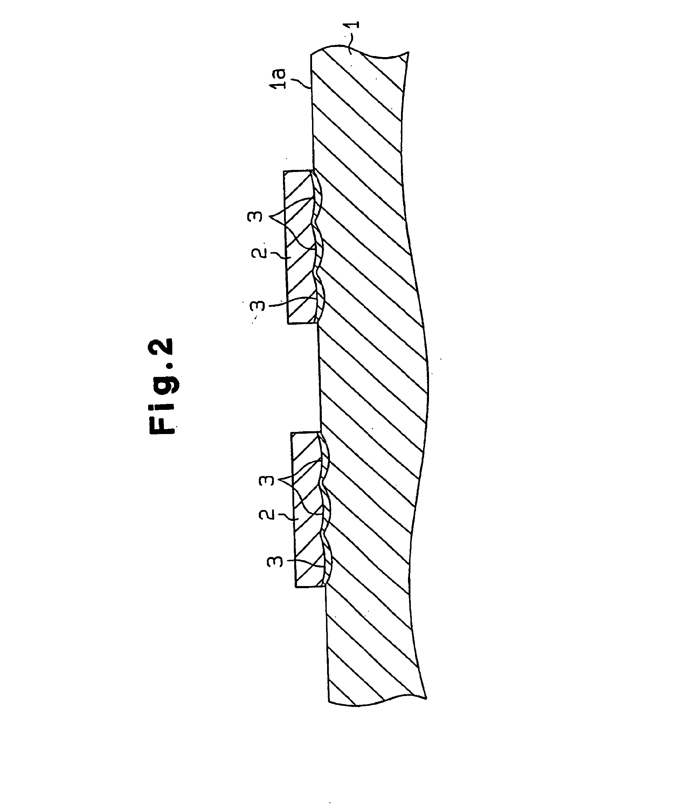

As the result of reaction between ruthenium dioxide and the oxide, a complex compound 3 comprising ruthenium, the glass frit, and oxygen at the interface is produced on the adhesion surface between the ceramic substrate 1 and the resistor 2, as shown in Fig. 2. The intervention of the complex compound 3 allows the resistor 2 to be firmly bonded to the aluminum nitride substrate 1.

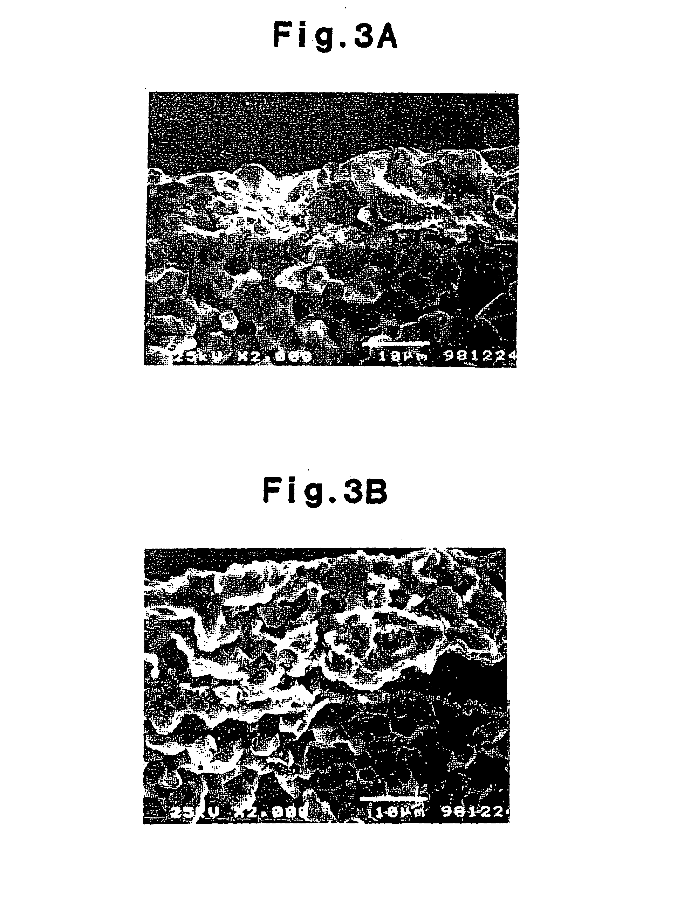

When the ceramic substrate 1 is, for example, the aluminum nitride substrate 1, aluminum nitride reacts with an oxide in the glass frit to generate alumina. At this time, the aluminum nitride substrate 1 partially dissolves, and alumina enters the concave portions formed by the dissolution. Therefore, this reaction itself basically contributes to the improvement of adhesive properties between the aluminum nitride substrate 1 and the resistor 2. However, this reaction inconveniently generates a large amount of a nitrogen gas. For this reason, the nitrogen gas pushes up the resistor 2 from the inside, which leads to noticeable peeling of the resistor 2 as shown in Fig. 3B.

When the ceramic substrate 1 is, for example, the silicon carbide substrate 1, silicon carbide and the oxide in the glass frit react to generate silica. At this time, the aluminum nitride substrate 1 partially dissolves, and silica enters the concave portions formed by the dissolution. Therefore, this reaction itself basically contributes to the improvement of the adhesive properties between the silicon carbide substrate 1 and the resistor 2. However, this reaction generates a large amount of carbon monoxide gas. In consequence, the carbon monoxide gas pushes up the resistor 2 from the inside, which leads to large-scale detachment of the resistor 2 as shown in Fig. 3B in the same way.

According to the present invention, the addition of ruthenium oxide controls the above gas so that it is not generated in a large amount, thereby improving the adhesive properties between the ceramic substrate 1 and the resistor 2 as shown in Fig. 3A.

It will hereafter be described in more detail by giving several more concrete Reference Examples and Comparative Example.

### <Preparation of Paste>

Noble metal particles, ruthenium dioxide, a glass frit, a resin binder (ethyl cellulose) and a solvent (a mixture of α-terprneol : butylcarbitol = 2 : 8 (volume ratio)) are sufficiently kneaded to produce the resistor pastes of Reference Examples 1 to 5 and Comparative Example.

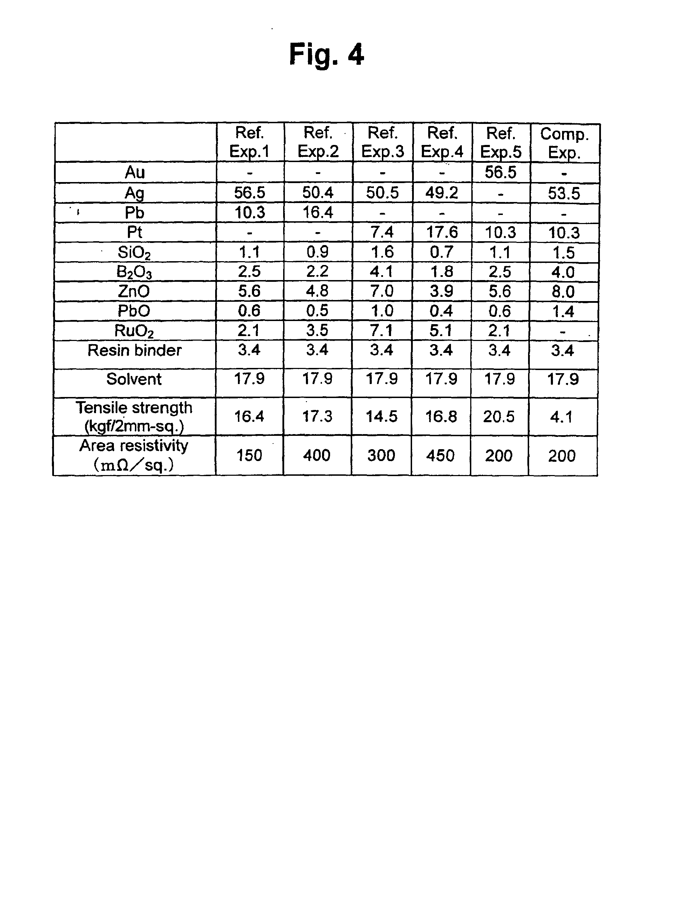

The compositions of the respective pastes are as shown in Table of Fig. 4. As the noble metal particles, those that have the average particle diameter of 4.5 µm and that are scaly were used. In Table, the compositions are indicated by weight ratio relative to the total amount of the pastes. Although the pastes of the respective Reference Examples are slightly different in their compositions, any of them is suitable to be used for a nonoxide ceramic, such as aluminum nitride or silicon carbide.

### <Production of Specimen>

An alcohol was kneaded with 100 parts by weight of aluminum nitride powder (average particle diameter of 1.1 µm), 4 parts by weight of yttria (average particle diameter of 0.4 µm) and 12 parts by weight of an acrylic resin binder, and then granular powder was obtained by a spray-drier method. The granular powder was cast in a forming mold, and molded into a flat board shape so as to obtain a molding. In this molding, an insertion hole for inserting a semiconductor wafer supporting pin and a concave portion for embedding a thermoelectric couple were made by drill processing. Then, the molding was hot-pressed under conditions of approximately 1800°C and 200 kg/cm², whereby an aluminum nitride sintered product having a, thickness of 3 mm was obtained. This sintered product was cut into a spherical shape having a diameter of 210 mm, and used as the aluminum nitride substrate 1 for a disk-shaped heater.

The pastes of Reference Examples 1 to 4 and Comparative Example above were applied to the aluminum nitride substrate 1 by the screen printing method such that the substrate may have the shape of the resistor 2 shown in Fig. 1. Then, the substrate 1 was baked in the nitrogen atmosphere and at 850°C, and the pastes were baked onto it. An aluminum nitride heater 1 obtained in this way was used as the specimen for Reference Examples 1 to 4 and Comparative Example. In Reference Examples 1 to 4 and Comparative Example, the pastes that contain the most silver in the composition were used.

Furthermore, another specimen was produced in the following method:

First, 0.5 parts by weight of carbon was added to 100 parts by weight of silicon carbide powder (average particle diameter of 1.1 µm) to be used as a starting material, and the molding was obtained in the above-mentioned manner. Then, the drill processing was applied to the molding before it was hot-pressed under the conditions of 1900°C, 200 kg/cm², whereby a silicon carbide sintered product having a thickness of 3 mm was obtained.

Furthermore, the glass paste was applied to the surface of the silicon carbide sintered product, and was heated at 800°C, thereby forming a glass layer that played a role as an insulating layer on the surface of the silicon carbide sintered product. Next, the paste of Reference Example 5 was screen-printed on the surface of the glass layer, and then the silicon carbide substrate 1 was baked in the nitrogen atmosphere and at 850°C, and thus the silicon carbide heater 1 of Reference Example 5 was obtained. In Reference Example 5, the paste that contains the most gold in the composition (concretely, Au-Pt paste) was used.

In either of the specimens, the resistor 2 had a thickness of approximately 5 to 10 µm and a width of approximately 2.4 mm.

### <Test Example 1>

For each specimen, tensile strength of the resistor 2 was measured. More concretely, the resistor 2 which is formed into a size of 2 mm-square was used as a test piece, and a 90-degree peeling test was carried out for each of the specimen. For the peeling test, "autograph" manufactured by Shimadzu Corporation was used. In this peeling test, a tension speed was set at 5 mm/minute.

### <Test Example 2>

Furthermore, the area resistivity of the resistor 2 was measured for each specimen. More concretely, the resistance of the resistor 2 that was formed into a thickness of 1.0 µm, a width of 5 mm, and a length of 5 cm was measured by a multimeter, and the area resistivity was calculated on the basis, of the measurement result. The results of the above respective tests are shown in Table 1.

As described above, according to the ceramic heater of the present invention, the resistor 2 is very firmly bonded to the aluminum nitride substrate 1 and the silicon carbide substrate 1. Consequently, the ceramic heater is superior in durability and reliability, and its industrial utility value is improved.

Furthermore, when the resistor paste for the ceramic heater according to the present invention is baked onto the ceramic substrate 1, it is certainly possible to obtain the ceramic heater that has the above advantages.

When the paste includes silver as the main component, it is possible to improve heat resistance and reduce material costs.

The embodiment and Examples that have so, far been described are not intended to limit thereto. The present invention is not limited hereto, and may be improved within the scope of the appended claims.

## Claims

1. A ceramic heater provided with a resistor on a ceramic substrate, wherein the resistor comprises at least two kinds of noble metal particles, ruthenium dioxide, and a glass frit.

2. The ceramic heater according to claim 1, wherein the ceramic substrate is a nonoxide ceramic substrate.

3. The ceramic heater according to claim 1, wherein the ceramic substrate is a nitride ceramic substrate.

4. The ceramic heater according to claim 1, wherein the ceramic substrate is an aluminum nitride substrate.

5. The ceramic heater according to claim 1, wherein the ceramic substrate is a silicide ceramic substrate or a carbide ceramic substrate.

6. The ceramic heater according to claim 1, wherein the ceramic substrate is a silicon carbide substrate.

7. The ceramic heater according to any one of claims 1 to 6, wherein the noble metal particles are at least two kinds selected from silver particles, gold particles, platinum particles, and palladium particles.

8. The ceramic heater according to claim 3 or 4, wherein the noble metal particles are silver particles and at least one kind selected from gold particles, platinum particles, and palladium particles.

9. The ceramic heater according to claim 8, wherein in a composition of the resistor, the silver particles are contained more than at least one kind selected from gold particles, platinum particles, and palladium particles.

10. The ceramic heater according to claim 5 or 6, wherein the noble metal particles are gold particles and at least one kind selected from silver particles, platinum particles, and palladium particles.

11. The ceramic heater according to claim 10, wherein in a composition of the resistor, the gold particles are contained more than at least one kind selected from silver particles, platinum particles, and palladium particles.

12. The ceramic heater according to any one of claims 1 to 11, wherein an average particle diameter of the noble metal particles is in a range of 0.1 µm to 10 µm.

13. The ceramic heater according to any one of claims 1 to 12, wherein a shape of the noble metal particles is scaly.

14. A resistor paste for a ceramic heater comprising noble metal particles, ruthenium dioxide, a glass frit, and an organic vehicle.

15. The resistor paste for a ceramic heater according to claim 14, wherein the noble metal particles are at least one kind selected from silver particles, gold particles, platinum particles, and palladium particles.

16. The resistor paste for a ceramic heater according to claim 14, wherein the noble metal particles are at least two kinds selected from silver particles, gold particles, platinum particles, and palladium particles.

17. The resistor paste for a ceramic heater according to claim 14, wherein the noble metal particles are silver particles and at least one kind selected from gold particles, platinum particles, and palladium particles.

18. The resistor paste for a ceramic heater according to claim 17, wherein in a composition of the paste, the silver particles are contained more than at least one kind selected from gold particles, platinum particles, and palladium particles.

19. The resistor paste for a ceramic heater according to claim 14, wherein the noble metal particles are gold particles'and at least one kind selected from silver particles, platinum particles, and palladium particles.

20. The resistor paste for a ceramic heater according to claim 19, wherein in a composition of the paste, the gold particles are contained more than at least one kind selected from silver particles, platinum particles, and palladium particles.

21. The resistor paste for a ceramic heater according to any one of claims 14 to 20, wherein an average particle diameter of the noble metal particles is in a range of 0.1 µm to 10 µm.

22. The resistor paste for a ceramic heater according to any one of claims 14 to 21, wherein a shape of the noble metal particles is scaly.
